# EUROPÄISCHE PATENTSCHRIFT

(11) **EP 1 900 088 B1**
(45) Veröffentlichungstag und Bekanntmachung des Hinweises auf die Patenterteilung: **18.02.2009**
(21) Anmeldenummer: 06755122.6
(22) Anmeldetag: 10.05.2006
(51) Int. Cl.: H02M 5/257, G01R 19/165

(54) **SCHALTUNGSANORDNUNG ZUR ERMITTLUNG VON NULLDURCHGÄNGEN EINER WECHSELSPANNUNG**
CIRCUIT ARRANGEMENT FOR DETECTING ZERO CROSSINGS OF AN ALTERNATING VOLTAGE
DISPOSITIF CIRCUIT POUR DETERMINER LES PASSAGES PAR ZERO D'UNE TENSION ALTERNATIVE

(30) Priorität: 30.06.2005 DE 102005030634
(43) Veröffentlichungstag der Anmeldung: 19.03.2008
(73) Patentinhaber: BSH Bosch und Siemens Hausgeräte GmbH, 81739 München (DE)
(72) Erfinder: HELMSCHMIDT, Holger, 93049 Regensburg (DE)
(86) Internationale Anmeldenummer: PCT/EP2006/062202
(87) Internationale Veröffentlichungsnummer: WO 2007/003459

(56) Entgegenhaltungen:
- US-A- 4 137 504
- US-B1- 6 380 692

## Beschreibung

Die Erfindung bezieht sich auf eine Schaltungsanordnung zur Ermittlung von Nulldurchgängen einer Wechselspannung, die in ihrem Verlauf durch ihr überlagerte Störimpulse beeinträchtigt sein kann und die zur Speisung eines elektrischen Gerätes, insbesondere Hausgerätes dient.

In elektrischen Geräten und insbesondere in elektrischen Hausgeräten enthaltene Verbraucher, Aktoren und Sensoren werden häufig mit Netzwechselspannungen durch Phasenanschnittschaltungen gespeist (siehe beispielsweise DE 29 38 989 A1, DE 30 22 500 C2, DE 32 33 516). Die in solchen Phasenanschnittschaltungen als Schaltelemente eingesetzten Halbleiterbauelemente, nämlich Thyristoren oder Triacs, werden im Laufe einer oder beider Netzwechselspannungs-Halbwellen in ihren leitenden Zustand gesteuert, und sie werden bei jedem Nulldurchgang der betreffenden Netzwechselspannungs-Halbwellen wieder in den nichtleitenden Zustand überführt bzw. gelöscht. Damit hat aber die Ermittlung der Nulldurchgänge der jeweiligen Wechselspannung eine entscheidende Bedeutung für das ordnungsgemäße Arbeiten der erwähnten Phasenanschnittschaltungen und daher auch der damit ausgestatteten Geräte bzw. Hausgeräte.

Es kann nun vorkommen, dass der Verlauf einer Wechselspannung, mit der ein Gerät bzw. Hausgerät gespeist wird, durch ihr überlagerte Störimpulse derart beeinträchtigt ist, dass Nulldurchgänge bereits zu solchen Phasen der Netzwechselspannung vorgetäuscht werden, zu denen solche Nulldurchgänge an sich nicht vorhanden sind. In diesem Fall kann es zu einem fehlerhaften Arbeiten der mit einer solchen Netzwechselspannung betriebenen Phasenanschnittschaltungen und damit der dadurch gespeisten Geräte kommen.

Darüber hinaus ist es in Hausgeräten notwendig, dass in diesen enthaltene Verbraucher, Aktoren und Sensoren, die jeweils mit einer Netzwechselspannung oder mit einer davon abgeleiteten Wechselspannung gespeist werden, synchron betrieben werden. Damit kommt aber der Ermittlung von Nulldurchgängen einer Wechselspannung auch in diesem Fall ganz erhebliche Bedeutung zu. Werden nämlich Nulldurchgänge der betreffenden Wechselspannung durch dieser überlagerte Störimpulse vorgetäuscht, so können gegebenenfalls zumindest einige Verbraucher, Aktoren oder Sensoren im jeweiligen Gerät nicht mehr korrekt angesteuert werden, und außerdem können von Sensoren in einem solchen Gerät gelieferte Signale gegebenenfalls nicht synchron mit der tatsächlichen Wechselspannung erfasst werden. Das Dokument US 6 380 692 schlägt ein aktives Filter vor, mit dem Oberschwingungen aus der Eingangsspannung herausgefiltert werden können, die sonst die Nulldurchgänge der Grundschwingung verfälschen würden.

Der Erfindung liegt daher die Aufgabe zugrunde, eine Schaltungsanordnung der eingangs genannten Art so aufzubauen, dass mit insgesamt relativ geringem schaltungstechnischen Aufwand die Nulldurchgänge einer Wechselspannung in dem Fall sicher ermittelt werden können, dass dieser Wechselspannung Störimpulse überlagert sind, die solche Spannungseinbrüche bewirken, dass dadurch gewissermaßen Nulldurchgänge der Wechselspannung an Stellen vorgetäuscht werden, an denen normalerweise keine auftreten.

Gelöst wird die vorstehend aufgezeigte Aufgabe durch eine Schaltungsanordnung gemäß Anspruch 1 dadurch, dass eine Überlagerungsschaltung vorgesehen ist, der die Wechselspannung über eine einen Tiefpasscharakter aufweisende Glättungsschaltung zugeführt ist und in der diese zugeführte Wechselspannung einer solchen Gleichspannung überlagert ist, dass die Nulldurchgänge der in der so gebildeten Summenspannung enthaltenen Wechselspannung im positiven Gleichspannungsbereich liegen, und dass der Überlagerungsschaltung eine Spannungsauswerteschaltung nachgeschaltet ist, die einen der Höhe der Gleichspannung entsprechenden Schwellwert aufweist und die bei den Nulldurchgängen der in der Summenspannung enthaltenen Wechselspannung ihren Ausgangspegel ändert.

Durch diese Schaltungsmaßnahmen wird der Vorteil einer sicheren Ermittlung von Nulldurchgängen der genannten Wechselspannung erreicht. Die erwähnte Glättungsschaltung bewirkt nämlich, dass die erwähnten Störimpulse so abgeflacht werden, dass durch sie keine Nulldurchgänge der betreffenden Wechselspannung vorgetäuscht werden. Die genannte Überlagerungsschaltung ermöglicht in Verbindung mit der ihr nachgeschalteten Spannungsauswerteschaltung, die betreffende Wechselspannung hinsichtlich ihrer Nulldurchgänge einfach auszuwerten. Von der betreffenden Spannungsauswerteschaltung wird dabei eine definierte Rechteckimpulsfolge mit der Wechselspannungsfrequenz abgegeben. Mit dieser Rechteckimpulsfolge lassen sich zum Beispiel die in einem Hausgerät enthaltenen unterschiedlichen Aktoren und Sensoren synchron speisen, also steuern bzw. abfragen.

Zweckmäßigerweise ist die genannte Wechselspannung eine Einphasen-Netzwechselspannung, die über einen Spannungsteiler der Glättungsschaltung zugeführt ist. Dadurch lässt sich auf besonders einfache Weise die der Überlagerungsschaltung mit entsprechender Amplitude zuzuführende Wechselspannung bereitstellen.

Die erwähnte Spannungsauswerteschaltung ist vorzugsweise nach Art einer Schmitt-Triggerschaltung aufgebaut. Dies bringt den Vorteil einer besonders einfach aufzubauenden Spannungsauswerteschaltung mit sich.

Zweckmäßigerweise enthält die Spannungsauswerteschaltung einen zwei Eingänge aufweisenden Spannungsvergleicher, dessen einer Eingang die genannte Summenspannung zugeführt erhält und dessen anderem Eingang eine in der Höhe betreffenden Gleichspannung entsprechende Vergleichsspannung zugeführt ist. Hierdurch ergibt sich der Vorteil einer besonders einfach aufzubauenden Spannungsauswerteschaltung.

Der zuvor erwähnte Spannungsvergleicher ist zweckmäßigerweise durch einen Transistor, und zwar insbesondere durch einen bipolaren Transistor gebildet, der an seinen Eingangselektroden, nämlich an seiner Basis bzw. an seinem Emitter die genannte Summenspannung bzw. die genannte Vergleichsspannung zugeführt erhält. Dadurch lässt sich der genannte Spannungsvergleicher besonders einfach realisieren.

Der gerade erwähnte eine bipolare Transistor ist vorzugsweise kollektorseitig mit der Basis eines weiteren bipolaren Transistors verbunden, der insbesondere von einem Leitfähigkeitstyp ist, welcher entgegengesetzt zum Leitfähigkeitstyp des erstgenannten bipolaren Transistors ist; der betreffende weitere bipolare Transistor ist zweckmäßigerweise in Emitter-Grundschaltung betrieben und gestattet an einem ohmschen Kollektor-Widerstand eine Ausgangsspannung abzunehmen. Hierdurch lassen sich in vorteilhafter Weise von dem genannten weiteren bipolaren Transistor Ausgangsimpulse abnehmen, die mit den Wechselspannungshalbwellen phasengleich auftreten, welche dem erstgenannten bipolaren Transistor eingangsseitig zugeführt werden.

Zweckmäßigerweise liegt zwischen der Basis des genannten weiteren bipolaren Transistors und einem Anschluss (-) einer Speisespannungsquelle für die beiden bipolaren Transistoren ein Kondensator. Dadurch wird auf relativ einfache Weise eine sichere Ansteuerung des genannten weiteren bipolaren Transistors sichergestellt.

Anhand von Zeichnungen wird die Erfindung nachstehend beispielhaft näher erläutert.
- Fig. 1: zeigt in einem Schaltungsdiagramm eine Schaltungsanordnung gemäß einer Ausführungsform der Erfindung.
- Fig. 2: veranschaulicht in einem Signaldiagramm den Verlauf von Spannungen an verschiedenen Schaltungspunkten der in Fig. 1 dargestellten Schal- tungsanordnung.

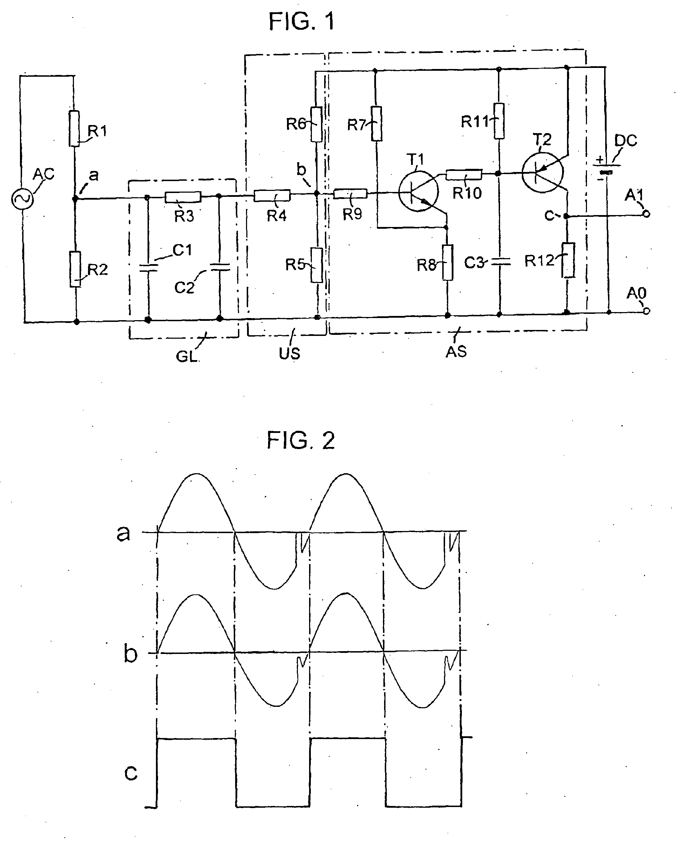

Die in Fig. 1 dargestellte Schaltungsanordnung dient zur Ermittlung von Nulldurchgängen einer Wechselspannung, die in ihrem Verlauf durch überlagerte Störimpulse beeinträchtigt sein kann. Diese Wechselspannung wird gemäß Fig. 1 von einer Wechselspannungsquelle AC abgegeben, bei der es sich hier um eine Einphasen-Netzwechselspannungsquelle handeln mag, die eine Wechselspannung von beispielsweise 230 Veff abgibt.

Der Netzwechselspannungsquelle AC ist ein aus ohmschen Widerständen R1 und R2 bestehender Spannungsteiler parallelgeschaltet, an dessen Widerstand R2 eine Wechselspannung mit einer solchen Amplitude auftritt, die in nachfolgend näher betrachteten Schaltungsteilen zu verarbeiten ist. Der Effektivwert dieser am Widerstand R2 abfallenden Wechselspannung kann beispielsweise 2,5 Veff betragen.

Die am Widerstand R2 abfallende Wechselspannung wird vom Schaltungspunkt a einer einen Tiefpasscharakter aufweisenden Glättungsschaltung GL zugeführt, die im vorliegenden Fall aus Kondensatoren C1 und C2 und einem ohmschen Widerstand R3 besteht. Ausgangsseitig ist diese Glättungsschaltung GL mit einer Überlagerungsschaltung US verbunden, die im vorliegenden Fall aus ohmschen Widerständen R4, R5 und R6 besteht. Die von der Glättungsschaltung GL abgegebene Wechselspannung gelangt über den Widerstand R4 zum gemeinsamen Schaltungs- bzw. Verbindungspunkt b der Widerstände R5 und R6, die hier einen Spannungsteiler bilden, der an einer Gleichspannungsquelle DC angeschlossen ist, bei der es sich beispielsweise um die Versorgungsgleichspannungsquelle der Schaltungsanordnung handelt. Diese Versorgungsgleichspannungsquelle DC kann eine Versorgungsgleichspannung von beispielsweise 5 V abgeben. Die beiden Widerstände R5 und R6 können diese Spannung an ihrem gemeinsamen Schaltungs- bzw. Verbindungspunkt b auf beispielsweise +2,5 V, also auf die Hälfte der Versorgungsgleichspannung herunterteilen.

Mit dem gemeinsamen Schaltungs- bzw. Verbindungspunkt b der beiden Spannungsteiler-Widerstände R5, R6 und des Widerstands R4 ist der Eingang einer Spannungsauswerteschaltung AS verbunden. Diese Spannungsauswerteschaltung AS arbeitet hier nach Art einer Schmitt-Triggerschaltung. Sie enthält einen ersten bipolaren Transistor T1 vom npn-Leitfähigkeitstyp, der mit seiner Basis über einen ohmschen Strombegrenzungswiderstand R9 am Schaltungs- bzw. Verbindungspunkt b der Überlagerungsschaltung US angeschlossen ist. An diesem Schaltungs- bzw. Verbindungspunkt b tritt eine aus der geglätteten Wechselspannung vom Schaltungs- bzw. Verbindungspunkt a und der durch den Spannungsteiler aus den Widerständen R5 und R6 gelieferten Gleichspannung gebildete Summenspannung auf. Der Emitter des Transistors T1 liegt am gemeinsamen Verbindungspunkt zweier einen Spannungsteiler bildender ohmscher Widerstände R7 und R8, die ebenfalls an der Versorgungsgleichspannungsquelle DC angeschlossen sind.

Während die Basis des vorstehend betrachteten, als Spannungsvergleicher eingesetzten Transistors T1 gewissermaßen den einen Eingang eines Spannungsvergleichers darstellt, bildet der Emitter des Transistors T1 den zweiten Eingang des betreffenden Spannungsvergleichers. Die Emitterspannung des Transistors T1 ist durch die Spannungsteiler-Widerstände R7 und R8 auf eine der Höhe der am gemeinsamen Schaltungs- bzw. Verbindungspunkt b - der auch als Summenschaltungspunkt bezeichnet werden kann - auftretenden Gleichspannung entsprechende Vergleichsspannung festgelegt, und zwar unter Berücksichtigung des Basis-Emitter-Spannungsabfalls des Transistors T1.

Der Transistor T1 liegt mit seinem Kollektor über die Reihenschaltung eines ohmschen Widerstands R10 und eines ohmschen Widerstands R11 am Pluspol + der Gleichspannungsquelle DC. Mit dem Verbindungspunkt der beiden Widerstände R10 und R11 ist die Basis eines weiteren bipolaren Transistors T2 verbunden, der jedoch vom pnp-Leitfähigkeitstyp ist. Dieser Transistor T2 liegt mit seinem Emitter direkt am Pluspol + der Versorgungsgleichspannungsquelle DC, und mit seinem Kollektor ist er über einen ohmschen Widerstand R12 mit dem Minuspol - dieser Versorgungsgleichspannungsquelle DC verbunden. Die Basis des Transistors T2 ist ferner mit der einen Belegung eines Kondensator C3 verbunden, dessen andere Belegung mit dem Minuspol - der betreffenden Versorgungsgleichspannungsquelle DC verbunden ist. Der gemeinsame Schaltungs- bzw. Verbindungspunkt c des Kollektors des Transistors T2 und des Widerstands R12 ist mit einem Ausgangsanschluss A1 verbunden. Der andere Anschluss des Widerstands R12 und damit der Minus-Anschluss - der Versorgungsgleichspannungsquelle DC ist mit einem Ausgangsanschluss A0 verbunden.

Nachdem zuvor der Aufbau der in Fig. 1 dargestellten Schaltungsanordnung in dem für ein Verständnis der vorliegenden Erfindung erforderlichen Umfange erläutert worden ist, sei nunmehr auf die Arbeitsweise dieser Schaltungsanordnung unter Heranziehung des Diagramms gemäß Fig. 2 eingegangen.

Am Schaltungs- bzw. Verbindungspunkt a in Fig. 1 möge die in Fig. 2a dargestellte Wechselspannung auftreten, deren negative Halbwellen hier durch überlagerte Störimpulse in ihrem Verlauf beeinträchtigt sind. Die Beeinträchtigung ist dabei so stark, dass durch die betreffenden Störimpulse infolge von damit verbundenen starken Einbrüchen der betreffenden Wechselspannung gewissermaßen Nulldurchgänge der Wechselspannung vorgetäuscht werden.

Am Schaltungs- bzw. Verbindungspunkt b, also am Summenspannungspunkt gemäß Fig. 1 tritt dann die in Fig. 2b dargestellte Summenspannung auf, in der hier einer Gleichspannung von 2,5V die geglättete Wechselspannung überlagert ist, die aus der vom Verbindungspunkt a abgegebenen Wechselspannung gewonnen ist. Die in Fig. 2b dargestellte Gleichspannungs-Mittellinie, um die herum die betreffende Wechselspannung verläuft, besitzt somit eine Höhe von +2,5 V. Wie ersichtlich, sind in dieser Wechselspannung die durch Störimpulse hervorgerufenen Einbrüche des Wechselspannungsverlaufs gegenüber jenen in Fig. 2a deutlich verringert. Der Grund hierfür ist die Tiefpasswirkung der in Fig. 1 dargestellten Glättungsschaltung GL. Somit werden durch diese Spannungseinbrüche nicht mehr Nulldurchgänge der Wechselspannung vorgetäuscht, so dass der nunmehr erzielte Wechselspannungsverlauf gemäß Fig. 2b in der Spannungsauswerteschaltung AS sicher ausgewertet werden kann.

Die Glättungswirkung der Glättungsschaltung GL ist im übrigen umso wirkungsvoller, je niedriger die Grenzfrequenz des die Glättungsschaltung bildenden Tiefpassgliedes gelegt ist. Sie kann bei Auftreten von Stromimpulsen mit einer Störfrequenz oberhalb von 500 Hz für die 50-Hz-Netzwechselspannung zum Beispiel zwischen 50 Hz und 500 Hz festgelegt sein.

In der Spannungsauswerteschaltung AS wird der npn-Transistor T1 durch die positiven Halbwellen der in Fig. 2b dargestellten Wechselspannung in den leitenden Zustand gesteuert. In diesem leitenden Zustand entlädt er über seine Kollektor-Emitter-Strecke und die ohmschen Widerstände R8 und R10 den zuvor über den Widerstand R11 auf ein den pnp-Transistor T2 sperrendes positives Potential aufgeladenen Kondensator C3. Dadurch wird der pnp-Transistor T2 nunmehr in den leitenden Zustand gesteuert, so dass an dessen Kollektor und damit an dem den Kollektor-Widerstand dieses Transistors T2 bildenden ohmschen Widerstand R12 und am Schaltungsausgang A1 bezogen auf den Schaltungsausgang A0 ein positiver Spannungsimpuls mit dem in Fig. 2c gezeigten Verlauf auftritt. Mit Auftreten der negativen Halbwellen der in Fig. 2b dargestellten Wechselspannung wird der npn-Transistor T1 wieder in den gesperrten Zustand überführt. Dadurch wird die mit der Basis des pnp-Transistors T2 verbundene Belegung des Kondensators C3 von der Versorgungsgleichspannungsquelle DC über den ohmschen Widerstand R11 wieder auf positives Potential aufgeladen. Dies hat wiederum ein Sperren des Transistors T2 zur Folge, wie dies aus Fig. 2c hervorgeht.

Die Impulsflanken der so gebildeten Rechteckimpulsfolge treten, wie aus Fig. 2c ersichtlich ist, völlig synchron mit den Nulldurchgängen der Wechselspannung gemäß Fig. 2a auf; die Nulldurchgänge der Wechselspannung gemäß Fig. 2a sind damit sicher ermittelt. Die betreffende Rechteckimpulsfolge kann somit für eine synchrone Ansteuerung von zum Beispiel verschiedenen Verbrauchern, Aktoren und Sensoren eines zu speisenden Gerätes bzw. Hausgerätes herangezogen werden. Somit dient die Wechselspannung gemäß Fig. 2a durch die vorliegende Erfindung nicht unmittelbar, sondern mittelbar zur Speisung eines elektrischen Gerätes und insbesondere eines elektrischen Hausgerätes.

Abschließend sei noch angemerkt, dass der Gleichspannungspegel der Überlagerungsspannung, die am Verbindungs- bzw. Schaltungspunkt b in der in Fig. 1 dargestellten Schaltungsanordnung auftritt, nicht auf die Hälfte des Wertes der Versorgungsgleichspannung festgelegt zu sein braucht; er kann vielmehr auch auf einen anderen im positiven Gleichspannungsbereich liegenden Pegel festgelegt sein.

### Bezugszeichenliste

- a, b, c: Schaltungs- bzw. Verbindungspunkte
- A1: Ausgangsanschluss
- AC: Wechselspannungsquelle
- AO: Ausgangsanschluss
- AS: Spannungsauswerteschaltung
- C1, C2, C3: Kondensatoren
- DC: Versorgungsgleichspannungsquelle
- GL: Glättungsschaltung
- R1, R2, R3, R4, R5, R6, R7, R8, R9, R10, R11, R12: ohmsche Widerstände
- T1, T2: bipolare Transistoren
- US: Überlagerungsschaltung

## Patentansprüche

1. Schaltungsanordnung zur Ermittlung von Nulldurchgängen einer Wechselspannung, die in ihrem Verlauf durch ihr überlagerte Störimpulse beeinträchtigt sein kann und die zur Speisung eines elektrischen Gerätes, insbesondere eines elektrischen Hausgerätes dient, mit einer einen Tiefpasscharakter aufweisende Glättungsschaltung, der die Wechselspannung eingangsseitig zugeführt wird und der ausgangsseitig eine die Nulldurchgänge der Wechselspannung ermittelnde Spannungsauswerteschaltung nachgeschaltet ist, **dadurch gekennzeichnet, dass** zwischen der Ausgangsseite der Glättungsschaltung (GL) und der Eingangsseite der Spannungsauswerteschaltung (AS) eine Überlagerungsschaltung (US) geschaltet ist, welche der Wechselspannung (a) eine solche Gleichspannung überlagert, dass die Nulldurchgänge der in der so gebildeten Summenspannung (b) enthaltenen Wechselspannung im positiven Gleichspannungsbereich liegen, und dass die Spannungsauswerteschaltung (AS) einen der Höhe der Gleichspannung entsprechenden Schwellwert aufweist und bei den Nuildurchgängen der in der Summenspannung (b) enthaltenen Wechselspannung ihren Ausgangspegel ändert.

2. Schaltungsanordnung nach Anspruch 1, **dadurch gekennzeichnet, dass** die Wechselspannung eine Einphasen-Netzwechselspannung (AC) ist, die mittels eines Spannungsteilers (R1, R2) herabgesetzt der Gleichspannung überlagert ist.

3. Schaltungsanordnung nach Anspruch 1 oder 2, **dadurch gekennzeichnet, dass** die Spannungsauswerteschaltung (AS) nach Art einer Schmitt-Triggerschaltung aufgebaut ist.

4. Schaltungsanordnung nach Anspruch 3, **dadurch gekennzeichnet, dass** die Spannungsauswerteschaltung (AS) einen zwei Eingänge aufweisenden Spannungsvergleicher (T1) enthält, dessen einer Eingang die aus der genannten Gleichspannung und der Wechselspannung (a) gebildete Summenspannung (b) zugeführt erhält und dessen anderem Eingang eine der Höhe der betreffenden Gleichspannung entsprechende Vergleichsspannung zugeführt ist.

5. Schaltungsanordnung nach Anspruch 4, **dadurch gekennzeichnet, dass** der Spannungsvergleicher (T1) durch einen Transistor (T1) gebildet ist, der an seinen Eingangselektroden die genannte Summenspannung (b) bzw, die genannte Vergleichsspannung zugeführt erhält.

6. Schaltungsanordnung nach Anspruch 5, **dadurch gekennzeichnet, dass** der Transistor (T1) ein bipolarer Transistor (T1) ist, der die Summenspannung (b) an seiner Basis bzw. an seinem Emitter zugeführt erhält und der die genannte Vergleichsspannung an seinem Emitter bzw. an einer Basis zugeführt erhält, und dass der betreffende bipolare Transistor (T1) an seinem Kollektor über einen ohmschen Widerstand (R10, R11) eine Kollektorspannung zugeführt erhält.

7. Schaltungsanordnung nach Anspruch 6, **dadurch gekennzeichnet, dass** der genannte eine bipolare Transistor (T1) kollektorseitig mit der Basis eines weiteren bipolaren Transistors (T2) verbunden ist, der insbesondere von einem Leitfähigkeitstyp ist, welcher entgegengesetzt zum Leitfähigkeitstyp des erstgenannten bipolaren Transistors (T1) ist, und dass der betreffende weitere bipolare Transistor (T2) in Emitter-Grundschaltung betrieben ist und an einem ohmschen Kollektor-Widerstand (R12) eine Ausgangsspannung abzunehmen gestattet.

8. Schaltungsanordnung nach Anspruch 7, **dadurch gekennzeichnet, dass** zwischen der Basis des genannten weiteren bipolaren Transistors (T2) und einem Anschluss (-) einer Speisespannungsquelle (DC) für die beiden bipolaren Transistoren (T1, T2) ein Kondensator (C3) liegt.

## Claims

1. Circuit arrangement for detecting zero transitions of an alternating voltage, which can be impaired in its course by interference pulses superimposed thereon and which serves for power supply of an electric appliance, particularly an electric domestic appliance, comprising a smoothing circuit having a low-pass character, to which the alternating voltage is fed at the input side and downstream of which a voltage evaluating circuit detecting the zero transitions of the alternating voltage is connected at the output side, **characterised in that** connected between the output side of the smoothing circuit (GL) and the input side of the voltage evaluating circuit (AS) is a superimposition circuit (US) which superimposes on the alternating voltage (a) such a direct voltage that the zero transitions of the alternating voltage contained in the thus-formed sum voltage (b) lie in the positive direct voltage range and that the voltage evaluating circuit (AS) has a threshold value corresponding with the level of the direct voltage and changes its output level when zero transitions of the alternating voltage contained in the sum voltage (b) occur.

2. Circuit arrangement according to claim 1, **characterised in that** the alternating voltage is a single-phase mains alternating voltage (AC) on which the direct voltage reduced by means of a voltage divider (R1, R2) is superimposed.

3. Circuit arrangement according to claim 1 or 2, **characterised in that** the voltage evaluating circuit (AS) is constructed in the manner of a Schmitt trigger circuit.

4. Circuit arrangement according to claim 3, **characterised in that** the voltage evaluating circuit (AS) contains a voltage comparator (T1) having two inputs, to one of which is fed the sum voltage (b) formed from the said direct voltage and the alternating voltage (a) and to the other of which is fed a comparison voltage corresponding with the level of the respective direct voltage.

5. Circuit arrangement according to claim 4, **characterised in that** the voltage comparator (T1) is formed by a transistor (T1), to which is fed at the input electrodes thereof the said sum voltage (b) or the said comparison voltage.

6. Circuit arrangement according to claim 5, **characterised in that** the transistor (T1) is a bipolar transistor (T1), to which the sum voltage (b) is fed at the base or emitter thereof and to which the said comparison voltage is fed at the emitter or base thereof, and that a collector voltage is fed to the respective bipolar transistor (T1) at the collector thereof by way of a resistive impedance (R10, R11).

7. Circuit arrangement according to claim 6, **characterised in that** the said bipolar transistor (T1) is connected at the collector side with the base of a further bipolar transistor (T2), which is, in particular, of a conductivity type opposite to the conductivity type of the first-mentioned bipolar transistor (T1), and that the respective further bipolar transistor (T1) is operated in emitter fundamental circuit and allows decrease in an output voltage at a resistive collector-resistor (R12).

8. Circuit arrangement according to claim 7, **characterised in that** a capacitor (C3) is present between the base of the said further bipolar transistor (T2) and a terminal (-) of a feed voltage source (DC) for the two bipolar transistors (T1, T2).

## Revendications

1. Dispositif de circuit pour détecter des passages par zéro d'une tension alternative dont le tracé est susceptible d'être affecté par des impulsions perturbatrices qui s'y superposent et qui sert à alimenter un appareil électrique, en particulier un appareil électroménager, avec un circuit de lissage qui présente un caractère passe-bas et sur lequel la tension alternative est envoyée côté entrée et en aval duquel est monté, côté sortie, un circuit d'évaluation de tension qui détecte les passages par zéro de la tension alternative, **caractérisé en ce qu'**est monté, entre le côté sortie du circuit de lissage (GL) et le côté entrée du circuit d'évaluation de la tension (AS), un circuit de superposition (US) qui superpose à la tension alternative (a) une tension continue telle que les passages par zéro de la tension alternative contenue dans la tension de somme (b) ainsi constituée se trouvent dans la plage de tension continue positive et **en ce que** le circuit d'évaluation de tension (AS) présente une valeur seuil qui correspond à la hauteur de la tension continue et modifie son niveau de sortie lors des passages par zéro de la tension alternative contenue dans la tension de somme (b).

2. Dispositif de circuit selon la revendication 1, **caractérisé en ce que** la tension alternative est une tension réseau alternative monophasée (AC) qui, réduite au moyen d'un diviseur de tension (R1, R2), est superposée à la tension continue.

3. Dispositif de circuit selon la revendication 1 ou 2, **caractérisé en ce que** l'architecture du circuit d'évaluation de tension (AS) est du type circuit bascule de Schmitt.

4. Dispositif de circuit selon la revendication 3, **caractérisé en ce que** le circuit d'évaluation de tension (AS) contient un comparateur de tension (T1) comportant deux entrées, sur une entrée duquel est envoyée la tension de somme (b) constituée à partir de ladite tension continue et de la tension alternative (a) et sur l'autre entrée duquel est envoyée une tension de comparaison qui correspond à la hauteur de la tension continue concernée.

5. Dispositif de circuit selon la revendication 4, **caractérisé en ce que** le comparateur de tension (T1) est constitué par un transistor (T1) sur les électrodes d'entrée duquel sont envoyées respectivement ladite tension de somme (b) et ladite tension de comparaison.

6. Dispositif de circuit selon la revendication 5, **caractérisé en ce que** le transistor (T1) est un transistor bipolaire (T1) sur la base respectivement sur l'émetteur duquel est envoyée la tension de somme (b) et sur l'émetteur resp. sur une base duquel est envoyée ladite tension de comparaison et **en ce qu'**une tension de collecteur est envoyée sur le collecteur du transistor bipolaire concerné (T1) par l'intermédiaire d'une résistance ohmique (R10, R11).

7. Dispositif de circuit selon la revendication 6, **caractérisé en ce que** ledit transistor bipolaire (T1) est relié, côté collecteur, à la base d'un autre transistor bipolaire (T2) qui est en particulier d'un type de conductivité opposé au type de conductivité dudit premier transistor bipolaire (T1), et **en ce que** l'autre transistor bipolaire concerné (T2) fonctionne en circuit émetteur basique et permet le prélèvement d'une tension de sortie au niveau d'une résistance ohmique de collecteur (R12).

8. Dispositif de circuit selon la revendication 7, **caractérisé en ce que** se trouve, entre la base dudit autre transistor bipolaire (T2) et un raccordement (-) d'une source de tension d'alimentation (DC) pour les deux transistors bipolaires (T1, T2), un condensateur (C3).
